# EUROPEAN PATENT APPLICATION

(11) **EP 4 819 789 A1**
(43) Date of publication of application: **07.10.2026**
(21) Application number: 25223660.9
(22) Date of filing: 16.12.2025
(51) Int. Cl.: H10D 1/20, H10W 70/60, H10W 70/685, H10W 90/00

(54) **MULTILAYER CORE PACKAGES WITH COAXIAL MAGNETIC INDUCTOR LOOPS AND EMBEDDED DEEP TRENCH CAPACITORS FOR VOLTAGE REGULATORS**

(30) Priority: 31.03.2025 US 202519095501
(71) Applicant: Intel Corporation, Santa Clara, CA 95054 (US)
(72) Inventor: MARIN, Brandon C., Gilbert, 85234 (US); KULIASHA, Cary, Mesa, 85202 (US); PIETAMBARAM, Srinivas Venkata Ramanuja, Chandler, 95249 (US); RADHAKRISHNAN, Kaladhar, Chandler, 85226 (US)
(74) Representative: 2SPL Patentanwälte PartG mbB

(57) **Abstract**

Disclosed herein are multilayer core packages with coaxial magnetic inductor loops (CMILs) and embedded deep trench capacitors (eDTCs) for voltage regulators, and related methods and devices. In one aspect, an example microelectronic assembly includes a first dielectric layer, a magnetic inductor integrated in the first dielectric layer, a second dielectric layer, a bonding interface between the first dielectric layer and the second dielectric layer, and a capacitor in a cavity in the second dielectric layer, wherein a footprint of the magnetic inductor at least partially overlaps with a footprint of the cavity in the second dielectric layer. The magnetic inductor may be a part of a CMIL. The capacitor may be a part of an eDTC.

## Description

### Background

A voltage regulator (VR) is an electronic circuit or device that maintains a stable output voltage regardless of variations in input voltage or load conditions. It ensures that electronic components receive a consistent and safe voltage, preventing damage and ensuring proper operation. VRs play a crucial role in delivering stable power to integrated circuits (ICs), e.g., in high-performance computing systems such as CPUs, GPUs, AI accelerators, etc.

Two important types of VRs used for power delivery in advanced computing systems are Fully Integrated Voltage Regulators (FIVRs) and Landside Voltage Regulators (Landside VRs). While both serve the same fundamental purpose-voltage regulation-they differ significantly in design, placement, and efficiency. FIVRs use coaxial magnetic inductor loops (CMILs) to regulate power efficiently. Landside VRs use buck converters with embedded deep trench capacitors (eDTCs) and discrete inductors to regulate voltage.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a schematic side, cross-sectional view of an example microelectronic assembly in which a multilayer core package with CMILs and eDTCs for VRs as described herein may be implemented, according to some embodiments of the present disclosure.
FIGS. 2A-2F are cross-sectional side views of example assemblies illustrating an example method of fabricating a multilayer core package with CMILs and eDTCs, in accordance with some embodiments.
FIG. 3 is a cross-sectional side view illustrating example details of a CMIL and an eDTC in a multilayer core package, in accordance with some embodiments.
FIG. 4 is a cross-sectional side view illustrating example alternative details of a CMIL that may be included in a multilayer core package, in accordance with some embodiments.
FIG. 5 is a cross-sectional side view illustrating example details of dielectric materials of a multilayer substrate with a multilayer core package with CMILs and eDTCs, in accordance with some embodiments.
FIG. 6 is a top view of a wafer and dies that may be included in a microelectronic assembly with a multilayer core package with CMILs and eDTCs in accordance with any of the embodiments disclosed herein, according to some embodiments of the present disclosure.
FIG. 7 is a side, cross-sectional view of an IC device that may be included in a microelectronic assembly with a multilayer core package with CMILs and eDTCs in accordance with any of the embodiments disclosed herein, according to some embodiments of the present disclosure.
FIG. 8 is a side, cross-sectional view of an IC device assembly that may include a multilayer core package with CMILs and eDTCs in accordance with any of the embodiments disclosed herein, according to some embodiments of the present disclosure.
FIG. 9 is a block diagram of an example communication device that may include a microelectronic assembly with a multilayer core package with CMILs and eDTCs in accordance with any of the embodiments disclosed herein, according to some embodiments of the present disclosure.

### Detailed Description

Disclosed herein are multilayer core packages with CMILs and eDTCs for VRs, and related methods and devices. The systems, methods, and devices of this disclosure each have several innovative aspects, no single one of which is solely responsible for all the desirable attributes disclosed herein. Details of one or more implementations of the subject matter described in this specification are set forth in the description below and the accompanying drawings.

For purposes of illustrating multilayer core packages with CMILs and eDTCs for VRs proposed herein, it might be useful to first understand phenomena that may come into play in semiconductor packaging. The following foundational information may be viewed as a basis from which the present disclosure may be properly explained. Such information is offered for purposes of explanation only and, accordingly, should not be construed in any way to limit the broad scope of the present disclosure and its potential applications.

As briefly described above, FIVRs regulate voltage using inductors (e.g., CMILs), while landside VRs rely on capacitors (e.g., buck converters with eDTCs). In advanced computing systems, both inductors and capacitors play a crucial role in efficient power conversion and noise filtering. LC filters in FIVRs ensure stable, noise-free power conversion with minimal electromagnetic interference, while deep trench capacitors in landside VRs enhance power efficiency by providing fast transient response and reducing supply noise. To maintain power integrity, minimize losses, and optimize overall power delivery network performance, advanced computing systems typically employ both FIVRs and landside VRs. To that end, CMILs and eDTCs may be implemented side by side in respective cavities within a core of an IC package.

Embodiments of the present disclosure are based on recognition that implementing CMILs and eDTCs in a coplanar manner may be suboptimal for some deployment scenarios due to the excessive footprint they occupy in the critical real estate of the core. To address this, an alternative approach is proposed in which an IC package includes two cores, forming a multilayer core package. In the proposed design, one or more CMILs are integrated in the first core, while one or more eDTCs are housed in a cavity within the second core, with the two cores attached in a manner that vertically stacks the CMILs and eDTCs. While this approach may slightly increase the overall package height, it significantly reduces the footprint occupied by the combination of CMILs and eDTCs. Additionally, vertically stacking CMILs and eDTCs in separate cores allows for unique microelectronic assembly architectures, such as frontside FIVRs paired with backside landside VR chiplets. Furthermore, implementing CMILs and eDTCs in separate cores supports a modular design, enhancing flexibility, scalability, maintainability, and cost efficiency in package development. In one aspect, an example microelectronic assembly includes a first dielectric layer, a magnetic inductor integrated in the first dielectric layer, a second dielectric layer, a bonding interface between the first dielectric layer and the second dielectric layer, and a capacitor in a cavity in the second dielectric layer, wherein a footprint of the magnetic inductor at least partially overlaps with a footprint of the cavity in the second dielectric layer. The magnetic inductor may be a part of a CMIL. The capacitor may be a part of an eDTC.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

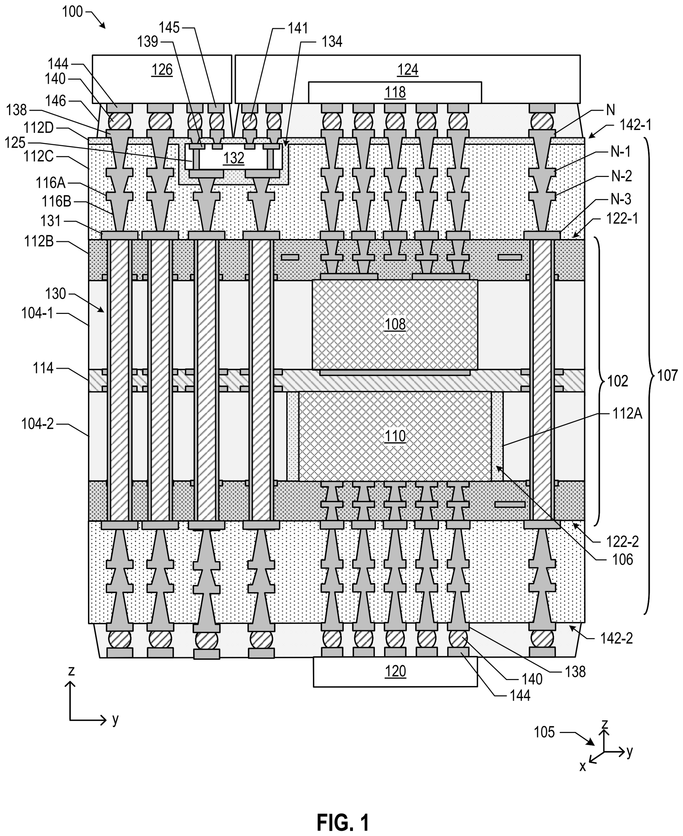

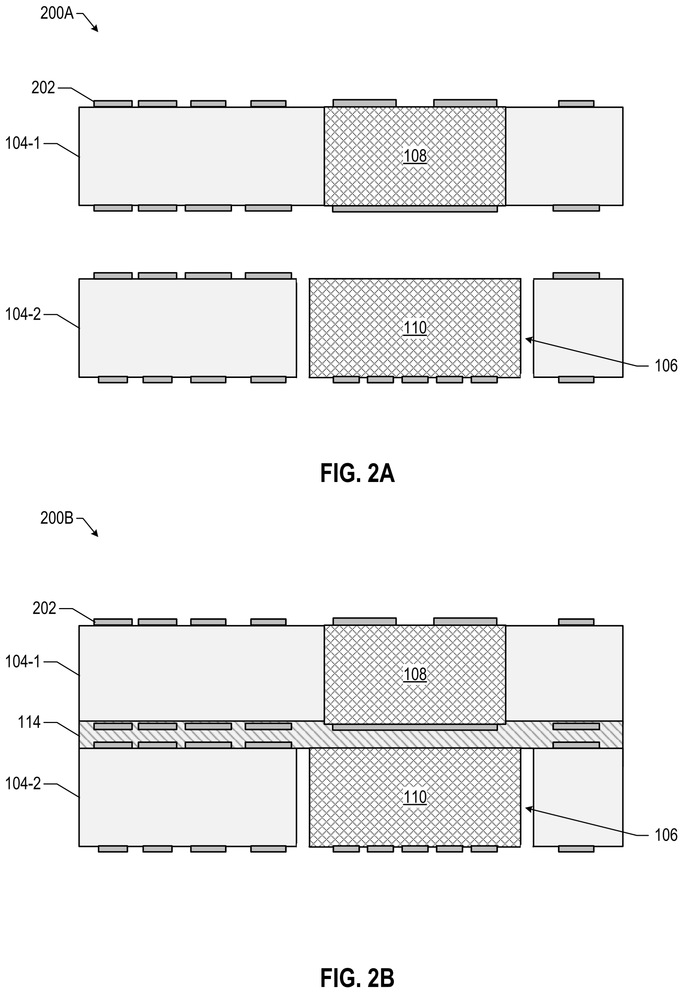

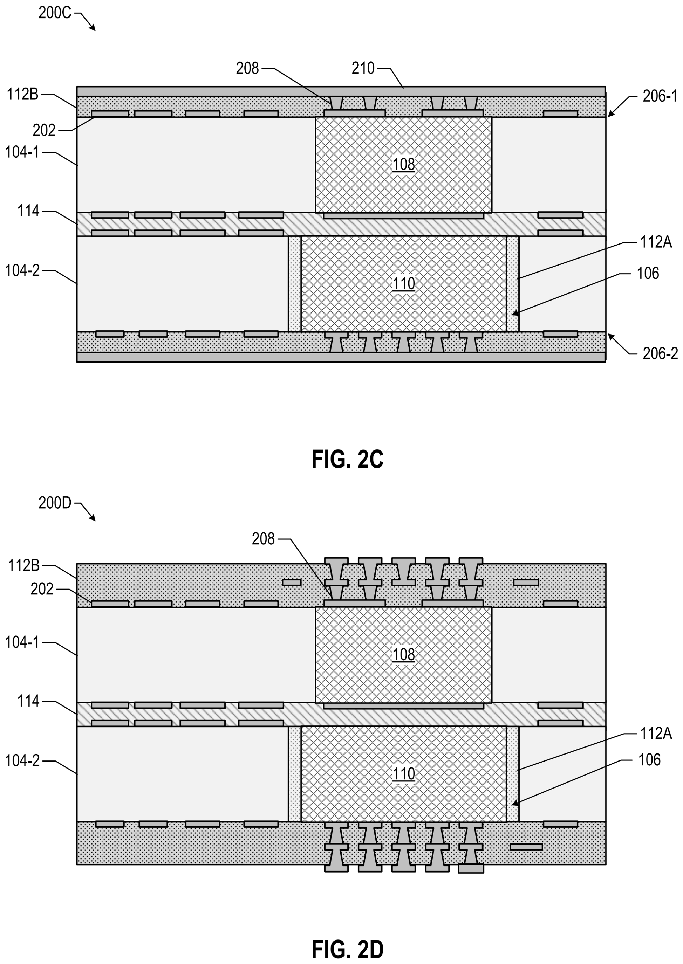

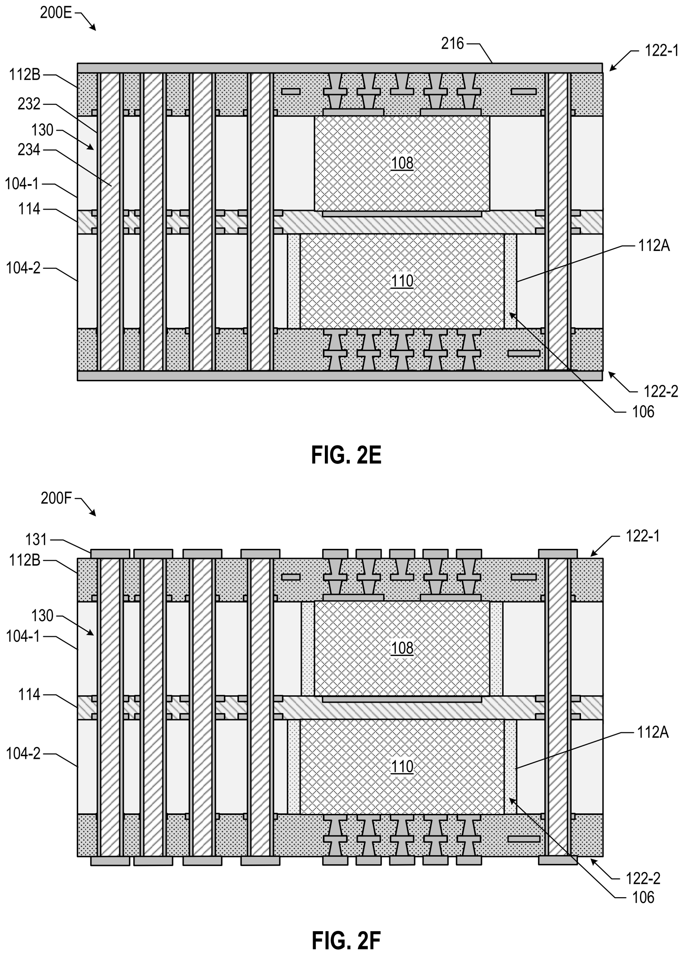

Any of the features discussed with reference to any accompanying drawings herein may be combined with any other features to form a microelectronic assembly 100, a multilayer core package 102, an IC device 1600, an IC device assembly 1700, or a communication device 1800, as appropriate. For convenience, the phrase "cores 104" may be used to refer to cores 104-1 and 104-2, the phrase "dielectric material 112" may be used to refer to a collection of dielectric materials 112A, 112B, 112C, etc. A number of elements of the drawings with same reference numerals may be shared between different drawings; for ease of discussion, a description of these elements provided with respect to one of the drawings is not repeated for the other drawings, and these elements may take the form of any of the embodiments disclosed herein. To not clutter the drawings, if multiple instances of certain elements are illustrated, only some of the elements may be labeled with a reference numeral (e.g., a plurality of conductive contacts 144 are shown in FIG. 1 but only one of the them is labeled with a reference numeral). Also to not clutter the drawings, not all reference numerals shown in one of the drawings are shown in other similar drawings. Furthermore, a plurality of drawings labeled with different letters may be referred to without a letter, e.g., FIGS. 2A-2F maybe referred to as "FIG. 2."

The drawings are not necessarily to scale. Although many of the drawings illustrate rectilinear structures with flat walls and right-angle corners, this is simply for ease of illustration and may not reflect real-life process limitations which may cause various features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers. There may be other defects not listed here but that are common within the field of semiconductor device fabrication and packaging. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of multilayer core packages with CMILs and eDTCs for VRs as described herein as described herein.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used to describe a range of dimensions, the phrase "between X and Y" represents a range that includes X and Y. When used to describe a location of an element, the phrase "between X and Y" represents a region that is spatially between element X and element Y. The terms "substantially," "close," "approximately," "near," and "about," generally refer to being within +/- 20%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 10%, e.g., within +/- 5% or within +/- 2%, of the exact orientation.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. As used herein, the terms "package" and "IC package" are synonymous, as are the terms "die" and "IC die." Furthermore, the terms "chip," "chiplet," "die," and "IC die" may be used interchangeably herein.

Although certain elements may be referred to in the singular herein, such elements may include multiple sub-elements. For example, "a dielectric material" may include one or more dielectric materials or "an insulator material" may include one or more insulator materials. The terms "oxide," "carbide," "nitride," etc. refer to compounds containing, respectively, oxygen, carbon, nitrogen, etc. The term "high-k dielectric" refers to a material having a higher dielectric constant than silicon oxide, while the term "low-k dielectric" refers to a material having a lower dielectric constant than silicon oxide. The term "insulating" and variations thereof (e.g., "insulative" or "insulator") means "electrically insulating," the term "conducting" and variations thereof (e.g., "conductive" or "conductor") means "electrically conducting," unless otherwise specified. With reference to optical signals and/or devices, components and elements that operate on or using optical signals, the term "conducting" can also mean "optically conducting." The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

FIG. 1 is a schematic side, cross-sectional view of one example microelectronic assembly 100 in which a multilayer core package 102 with CMILs and eDTCs for VRs as described herein may be implemented, according to some embodiments of the present disclosure. The multilayer core package 102 may include a core 104-1 and a core 104-2. In some embodiments, the cores 104 may be composed of materials that enhance mechanical support and stability, helping to reduce warpage of the microelectronic assembly 100. For example, the cores 104 may be relatively stiff structures compared to some other layers of the microelectronic assembly 100. However, more generally, the cores 104 may include any structures of any suitable material (e.g., any suitable dielectric material) that may house CMILs and eDTCs. The materials used for the cores 104 may depend on the type of package and performance requirements. In some embodiments, any of the cores 104 may include a material such as epoxy. In some embodiments, any of the cores 104 may be/include a pre-impregnated composite material (pre-preg), e.g., a fiber-reinforced material in which the fibers or clothes such as fiberglass, carbon fiber, or aramid are pre-impregnated with a resin system, e.g., within a thermosetting polymer like epoxy. In some embodiments, any of the cores 104 may include organic resin-based materials. Example of such materials include bismaleimide triazine (BT) resin, glass-reinforced epoxy (FR-4), or Ajinomoto Build-up Film (ABF). In some embodiments, any of the cores 104 may include glass substrates. Glass may be more rigid than organic resin-based materials and may have other advantages such as excellent thermal properties, low coefficient of thermal expansion (CTE), high electrical insulation, chemical resistance, optical transparency, and compatibility with advanced semiconductor properties. In some embodiments, any of the cores 104 may include ceramic materials, such as aluminum oxide, aluminum nitride, or silicon nitride.

The cores 104 may be bonded to one another, with a bonding material 114 in between. In some embodiments, the bonding material 114 may include a material such as epoxy, e.g., a pre-preg. In some embodiments, the material composition of the bonding material 114 may be substantially the same as that of the cores 104. In other embodiments, material compositions of the bonding material 114 may be different from that of the cores 104.

The core 104-2 may include a cavity 106 in which an eDTC 110 may be disposed. In some embodiments, the cavity 106 may be tapered, narrowing towards the bonding material 114. At least a portion of the remaining space in the cavity 106 may be filled with a dielectric material 112A. In some embodiments, the dielectric material 112A may include any of the materials described with reference to the cores 104, but even if the material composition of the dielectric material 112A and the core 104-2 is similar or the same, a seam may be detectable at the interface between the dielectric material 112A in the cavity 106 and the material of the cores 104-2. In some embodiments, the dielectric material 112A may include any of the materials described with reference to the bonding material 114, but even if the material composition of the dielectric material 112A and the bonding material 114 is similar or the same, a seam may be detectable at the interface between the dielectric material 112A in the cavity 106 and the bonding material 114. In other embodiments, no seam may be detectable between the dielectric material 112A and the bonding material 114 because the dielectric material 112A may be a portion of the bonding material 114 that was squeezed into the gaps in the cavity 106 during bonding of the cores 104.

Unlike the core 104-2 with a cavity 106, in some embodiments, the core 104-1 may include a CMIL 108 not in a cavity but embedded (e.g., monolithically integrated) in the core 104-1, as is shown in FIG. 1. However, in other embodiments, the CMIL 108 may also be included in a cavity in the core 104-1 (not shown), similar to the cavity 106 in the core 104-2. In cases where the CMIL 108 is fully nested within the core 104-1, the face of the CMIL 108 that is farthest away from the bonding material 114 may be planar with or below the face of the core 104-1 that is farthest away from the bonding material 114. In cases where the CMIL 108 is partially nested within the core 104-1 (not shown), the face of the CMIL 108 that is farthest away from the bonding material 114 may extend above the face of the core 104-1 that is farthest away from the bonding material 114. In an analogous manner, in cases where the eDTC 110 is fully nested in the cavity 106, the face of the eDTC 110 that is farthest away from the bonding material 114 may be planar with or below the face of the core 104-2 that is farthest away from the bonding material 114 and/or planar with or below the face of the dielectric material 112A in the cavity 106 that is farthest away from the bonding material 114. In cases where the eDTC 110 is partially nested in the cavity 106 (not shown), the face of the eDTC 110 that is farthest away from the bonding material 114 may extend above the face of the core 104-2 that is farthest away from the bonding material 114.

Providing the CMIL 108 and the eDTC 110 in different cores 104 allows arranging the CMIL 108 and the eDTC 110 so that they are substantially vertically stacked with respect to one another. In such an arrangement, footprints (e.g., projections onto the x-y plane of a coordinate system 105 shown in FIG. 1) of the CMIL 108 and the eDTC 110 may at least partially overlap. In some embodiments, the footprints of the CMIL 108 and the eDTC 110 may fully overlap. For example, in some embodiments, the footprint of the CMIL 108 may be fully within the footprint of the eDTC 110; although this may be reversed in other embodiments.

For any of the cores 104, a layer of a dielectric material 112B may be provided on the side that is opposite to that being bonded to the other core 104. Beyond that, an additional layer of a dielectric material 112C may be provided, so that, for each of the cores 104, the dielectric material 112B is between the core 104 and the dielectric material 112C. A conductive material may be used in the dielectric material 112B and the dielectric material 112C to provide conductive pads and contacts, described below. A conductive material may also be used in the dielectric material 112B and the dielectric material 112C to provide conductive pathways 116 (e.g., conductive traces 116A and conductive vias 116B) supporting electrical connectivity between the CMIL 108 and a FIVR 118 on a first side 122-1 of the multilayer core package 102, and electrical connectivity between the eDTC 110 and a landside VR 120 on a second side 122-2 (opposite the first side 122-1) of the multilayer core package 102. In some embodiments, the conductive material may include a metal (e.g., copper). However, more generally, any of the conductive materials described herein may include any suitable metal (e.g., tungsten, titanium, tantalum, copper, ruthenium, palladium, platinum, cobalt, nickel, etc.), metal alloy, or carbides or nitrides of one or more metals.

The FIVR 118 may be included within a component 124, e.g., an XPU. Additional components may be provided along the FIVR 118 and the landside VR 120, e.g., as shown in FIG. 2 with a component 126. Conductive pathways 116 may also provide electrical connectivity between one or more electronic components on the first side 122-1 of the multilayer core package 102 and one or more electronic components on the second side 122-2 of the multilayer core package 102, e.g., using conductive through-vias 130 extending between the first side 122-1 and the second side 122-2 of the multilayer core package 102. In some embodiments, each of the components 124 and 126 may be a die. In some embodiments, the landside VR 120 may be a die as well. In other embodiments, the landside VR 120 may be a surface-mounted component.

The conductive through-vias 130 may be vias extending between the first side 122-1 and the second side 122-2 of the multilayer core package 102 (e.g., between respective conductive contacts 131 at the top face and the bottom face of the arrangement of the cores 104 with the bonding material 114 in between). The conductive through-vias 130 may include any appropriate conductive material, e.g., a metal such as copper, silver, nickel, gold, aluminum, or other metals or alloys, for example. Openings for the conductive through-vias 130 may be formed using any suitable process. In some embodiments, the conductive through-vias 130 disclosed herein may have a pitch between 50 microns and 500 microns, e.g., as measured from a center of one conductive through-via 130 to a center of an adjacent conductive through-via 130. The conductive through-vias 130 may have any suitable size and shape. In some embodiments, the conductive through-vias 130 may have a circular, rectangular, or other shaped cross-section. In some embodiments, at least some of the conductive through-vias 130 may have an hourglass shape. In some embodiments, at least some of the conductive through-vias 130 may taper down from one face of the multilayer core package 102 to another, e.g., from the first side 122-1 of the multilayer core package 102 to the second side 122-2 of the multilayer core package 102.

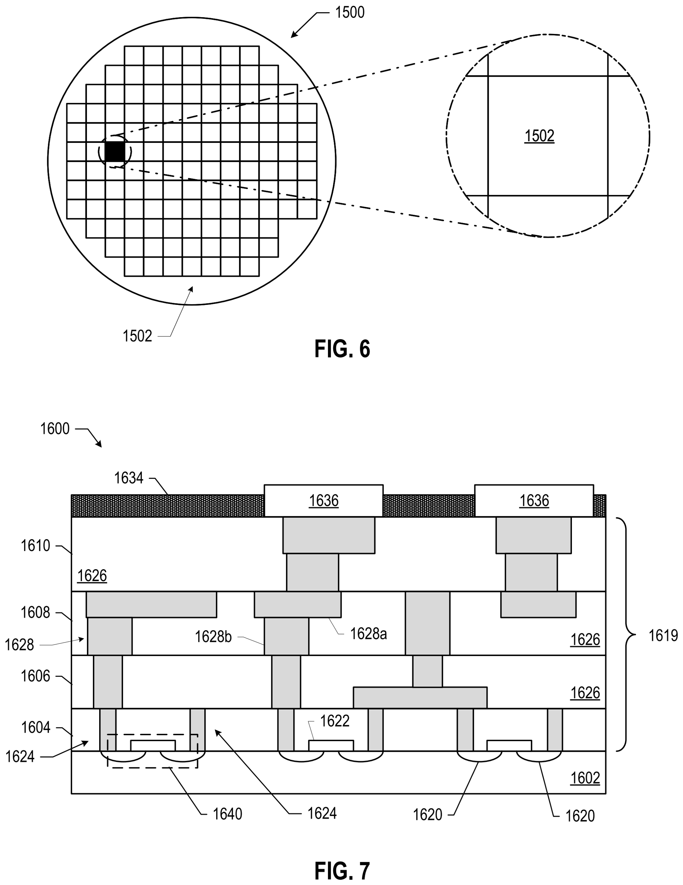

In some embodiments, any of the components 124, 126 may be or may include a memory device or a highfrequency serializer and deserializer (SerDes), such as a Peripheral Component Interconnect (PCI) express. In some embodiments, any of the components 124, 126 may be or may include a processing die, an RF chip, a power converter, a network processor, a workload accelerator, or a security encryptor. In some embodiments, any of the components 124, 126 may be a die, e.g., the die 1502 of FIG. 6.

If multiple components are provided over the dielectric material 112C on a given side of the multilayer core package 102, such components may be connected to one another using a bridge component (e.g., a bridge 132). In the example shown in FIG. 1, the bridge die 132 is used to connect the component 124 and the component 126. As shown in FIG. 1, the bridge 132 may be provided in a cavity 134 in the dielectric material 112C on the first side 122-1 of the multilayer core package 102. For example, the bridge 132 may be at least partially nested in the cavity 134. Remainder of the cavity 134 may at least partially be filled with a dielectric material 112D. In some embodiments, the bridge 132 may be embedded in the dielectric material 112D. In some embodiments, a cavity 134 may be tapered, narrowing towards a bottom face of the cavity 134 (e.g., the surface towards the first side 122-1 of the multilayer core package 102). A cavity 134 may be indicated by a seam between the dielectric material 112C and the dielectric material 112D. As shown in FIG. 1, in cases where the bridge 132 is partially nested in the cavity 134, a top face of the bridge 132 may extend above a top face of dielectric material 112C. In cases where the bridge 132 is fully nested in the cavity 134 (not shown), a top face of the bridge 132 may be planar with or below the top face of dielectric material 112C. In some embodiments, the bridge 132 may be a double-sided bridge 132 in that it may further be electrically coupled to a conductive pathway, e.g., a conductive trace 116A or a conductive via 116B, in a metal layer N-1 of the dielectric material 112C on the first side 122-1 that is beneath the bottom of the cavity 134.

In some embodiments, the bridge 132 may include conductive pathways to route power, ground, and/or signals to/from other components included in the microelectronic assembly 100. For example, the bridge 132 may include TSVs 125, including a conductive via, such as a metal via, isolated from the surrounding silicon or other semiconductor material by a barrier oxide), or other conductive pathways through which power, ground, and/or signals may be transmitted between one or more components "on top" of the bridge 132 (e.g., in the embodiment of FIG. 1, the component 124 and/or the component 126) and one or more components "below" the bridge 132 such as the landside VR 120 and/or a further component (not shown). The further component may, e.g., be a package substrate, a circuit board, a motherboard, or another die.

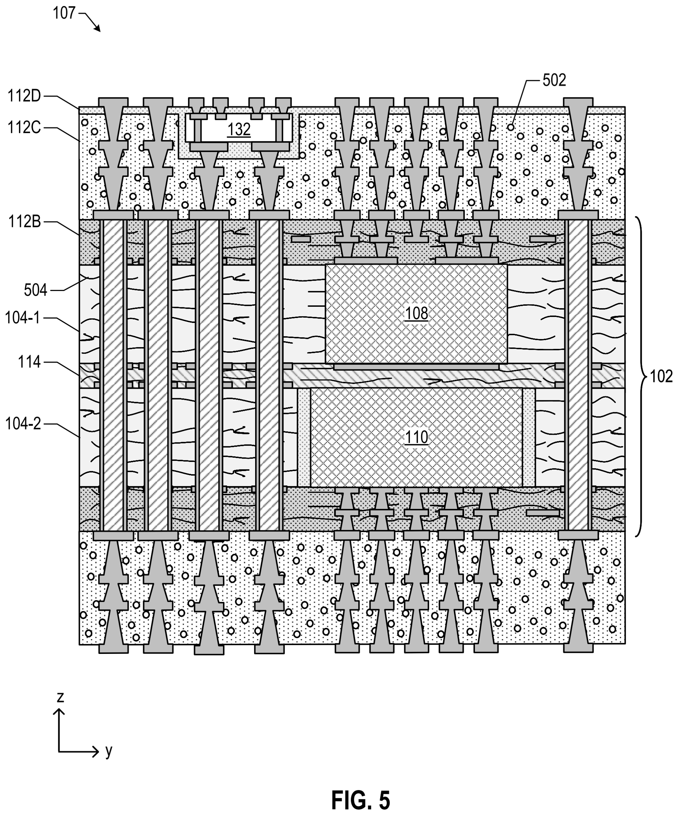

Together, the multilayer core package 102 and the dielectric materials 112C and 112D may provide a multilayer substrate 107. In some embodiments, the dielectric material 112 of the multilayer substrate 107 may be formed in layers. In some embodiments, the dielectric material 112 may include an organic material, such as an organic build-up film. In such embodiments, the layers of the dielectric materials 112C (and possibly the dielectric material 112D) may be referred to as build-up (BU) layers. In some embodiments, the dielectric materials 112C and 112D may include an epoxy film having filler particles therein, a glass, a ceramic, an inorganic material, or combinations of organic and inorganic materials, for example. In some embodiments, the dielectric materials 112C and 112D may include ABF. In some embodiments, materials of the dielectric material 112C and those of the dielectric material 112B, the cores 104, and the bonding material 114 may be clearly distinguishable in a cross-sectional image of the microelectronic assembly 100, as explained below with reference to FIG. 5.

In some embodiments, the multilayer substrate 107 may include layers of dielectric material 112C with lines/traces/pads/contacts (e.g., conductive traces 116A) of conductive material in one layer electrically coupled to lines/traces/pads/contacts (e.g., conductive traces 116A) of conductive material in an adjacent layer by vias (e.g., 116B) of the conductive material extending through the dielectric material 112. Conductive traces 116A may be referred to herein as "conductive lines," "conductive elements," "conductive pads," or "conductive contacts." A multilayer substrate 107 including such layers may be formed using a printed circuit board (PCB) fabrication technique, for example.

On each side of the multilayer core package 102, the multilayer substrate 107 may include N layers of conductive material forming conductive traces 116A, where N is an integer greater than or equal to one. In FIG. 1, the layers are labeled in descending order from the top face of the multilayer substrate 107 (i.e., the face farthest away from the landside VR 120) as layer N, layer N-1, layer N-2, etc. In particular, as shown in FIG. 1, a multilayer substrate 107 may include four metal layers (e.g., N, N-1, N-2, and N-3) in the dielectric material 116C at the first side 122-1 of the multilayer core package 102. Labeling of the layers is only shown for the layers in the dielectric material 116C at the first side 122-1 of the multilayer core package 102, but analogous applies to the dielectric material 116C at the second side 122-2 of the multilayer core package 102. In various embodiments, the same or different numbers of layers of conductive material forming conductive traces 116A may be used on different sides of the multilayer core package 102.

The metal layer N at the first side 122-1 of the multilayer core package 102 may include conductive contacts 138 at a first surface 142-1 of the multilayer substrate 107 that are coupled to conductive contacts 144 at bottom faces of the component 124 and the component 126 (e.g., the bottom face of the FIVR 118) by die-to-substrate (DTS) interconnects 140. Similarly, the metal layer N at the second side 122-2 of the multilayer core package 102 may include conductive contacts 138 at a second surface 142-2 of the multilayer substrate 107 that are coupled to conductive contacts 144 at bottom face of the landside VR 120 by DTS interconnects 140. The bridge 132 may be electrically coupled to the components 124, 126 by die-to-die (DTD) interconnects 141 at the first surface 142-1 of the multilayer substrate 107. In particular, conductive contacts 139 on a top face of the bridge 132 may be coupled to conductive contacts 145 on the bottom face of components 124, 126 by conductive vias 116B through the dielectric material 112D. In some embodiments, a pitch of the conductive contacts 144 may be between 25 microns and 250 microns. As used herein, pitch is measured center-to-center (e.g., from a center of a conductive contact to a center of an adjacent conductive contact). In some embodiments, a pitch of the conductive contacts 139 on the bridge 132 may be between 25 microns and 100 microns.

The DTS interconnects 140 and the DTD interconnects 141 disclosed herein may take any suitable form. In some embodiments, the DTD interconnects 141 may have a finer pitch than the DTS interconnects 140. In some embodiments, the DTS interconnects 140 and/or the DTD interconnects 141 may include solder. In some embodiments, the DTS interconnects 140 and/or the DTD interconnects 141 may include an anisotropic conductive material, such as any of the materials discussed above. In some embodiments, some or all of the DTS interconnects 140 and/or the DTD interconnects 141 in a microelectronic assembly 100 may be metal-to-metal interconnects (e.g., copper-to-copper interconnects, or plated interconnects). Any of the conductive contacts disclosed herein (e.g., the conductive contacts 131, 138, 139, 144, and/or 145) may include bond pads, solder bumps, conductive posts, or any other suitable conductive contact, for example. In some embodiments, the DTS interconnects 140 and/or the DTD interconnects 141 may include solder balls for a ball grid array arrangement, pins in a pin grid array arrangement or lands in a land grid array arrangement.

As used herein, a "conductive contact" may refer to a portion of conductive material (e.g., metal) serving as an electrical interface between different components (e.g., part of a conductive interconnect); conductive contacts may be recessed in, flush with, or extending away (e.g., having a pillar shape) from a surface of a component, and may take any suitable form (e.g., a conductive pad or socket, or portion of a conductive line or via). In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of a conductive material for providing electrical connectivity to one or more elements associated with the IC or/and between various such elements. In such cases, the term "interconnect" may refer to both conductive traces (also sometimes referred to as "metal traces," "lines," "metal lines," "wires," "metal wires," "trenches," or "metal trenches") and conductive vias (also sometimes referred to as "vias" or "metal vias"). Sometimes, conductive traces and vias may be referred to as "metal traces" and "metal vias", respectively, to highlight the fact that these elements include conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PIC. In such cases, the term "interconnect" may refer to optical waveguides (e.g., structures that guide and confine light waves), including optical fiber, optical splitters, optical combiners, optical couplers, and optical vias. As used herein, the terms "component," "microelectronic component," "die," and similar variations may be used interchangeably. As used herein, the terms "bridge," "bridge die," "interconnect component," and similar variations may be used interchangeably.

The microelectronic assembly 100 of FIG. 1 may also include an underfill material 146. In some embodiments, the underfill material 146 may extend between different ones of the top level components (e.g., the component 124 and the component 126) and the first surface 142-1 of the multilayer substrate 107 around the associated DTS interconnects 140 and between the bridge 132 and the top level components (e.g., the component 124 and the component 126) around the DTD interconnects 141. The underfill material 146 may be an insulating material, such as an appropriate epoxy material. In some embodiments, the underfill material 146 may include a capillary underfill, non-conductive film (NCF), or molded underfill. In some embodiments, the underfill material 146 may include an epoxy flux. The underfill material 146 may be selected to have a CTE that may mitigate or minimize the stress between the multilayer substrate 107 and components on various sides of the multilayer substrate 107 arising from uneven thermal expansion in the microelectronic assembly 100.

Although a particular number and arrangement of layers of dielectric material 112 and conductive pathways 116 are shown in various ones of the accompanying figures, these particular numbers and arrangements are simply illustrative, and any desired number and arrangement of dielectric material 112 and conductive pathways 116 may be used. Further, although a particular number of layers are shown in the multilayer substrate 107 (e.g., four layers), these layers may represent only a portion of the multilayer substrate 107, for example, further layers may be present (e.g., layers N-4, N-5, N-6, etc.).

In some embodiments, in the top-down view (e.g., the x-y plane of the coordinate system 105), the core 104 may have a first length in a range of 10 millimeters to 250 millimeters, and a second length in a range of 10 millimeters to 250 millimeters, the first length perpendicular to the second length. A thickness of the core 104 (e.g., a dimension measured along the z-axis of the coordinate system 105) may be in a range of about 50 micron to 3 millimeters. The cores 104 may, but do not have to, provide mechanical stability to the multilayer substrate 107 and/or the microelectronic assembly 100.

Various components of the microelectronic assembly 100 (e.g., FIVR 118, landside VR 120, components 124 or 126, or the bridge 132) disclosed herein may include an insulating material (e.g., a dielectric material formed in multiple layers, as known in the art) and multiple conductive pathways formed through the insulating material. In some embodiments, the insulating material of such components may include a dielectric material, such as silicon dioxide, silicon nitride, oxynitride, polyimide materials, glass-reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of such components may include a semiconductor material, such as silicon, germanium, or a III-V material (e.g., gallium nitride), and one or more additional materials. For example, an insulating material may include silicon oxide or silicon nitride. The conductive pathways in such components may include conductive traces and/or conductive vias and may connect any of the conductive contacts in such components in any suitable manner (e.g., connecting multiple conductive contacts on a same surface or on different surfaces of such components). Example structures that may be included in such components disclosed herein are discussed below with reference to the IC device 1600. The conductive pathways in such components may be bordered by liners, such as adhesion liners and/or barrier liners, as suitable. In some embodiments, any such components may be a die, a wafer, or a chip. In some embodiments, any such components may be a monolithic silicon, a fan-out or fan-in package die, or a die stack (e.g., wafer stacked, die stacked, or multilayer die stacked).

The microelectronic assembly 100 of FIG. 1 may also include a circuit board (not shown). The circuit board may be a motherboard, for example, and may have other components attached to it. The circuit board may include conductive pathways and other conductive contacts for routing power, ground, and signals through the circuit board, as known in the art.

Although FIG. 1 depicts a microelectronic assembly 100 having a substrate with a particular number of components (e.g., components 124 and 126) and conductive pathways in the form of conductive traces 116A and conductive vias 116B, this number and arrangement are simply illustrative, and a microelectronic assembly 100 may include any desired number and arrangement of the components other than the landside VR 120 and the FIVR 118. Although FIG. 1 shows the bridge 132 as a double-sided die and the components 124 and 126 as single-sided dies, in various embodiments of the microelectronic assembly 100, any of the components 124 and 126, as well as the landside VR 120, may be double-sided dies, and/or the bridge 132 may be a single-sided die (e.g., attached to the bottom of the cavity 134 using an adhesive). In some embodiments, additional components may be disposed on the top face of the components 124 and 126 and/or on the bottom face of the landside VR 120. In this context, a double-sided component/die refers to a component/die that has connections on both surfaces. In some embodiments, a double-sided component/die may include through TSVs to form connections on both surfaces. The active surface of a double-sided component/die, which is the surface containing one or more active devices and a majority of interconnects, may face either direction depending on the design and electrical requirements.

FIGS. 2A-2F are cross-sectional side views of example assemblies illustrating an example method of fabricating a multilayer core package with CMILs and eDTCs, in accordance with some embodiments.

FIG. 2A illustrates an assembly 200A in which the cores 104-1 and 104-2 are separate from one another. The core 104-1 includes a CMIL 108 that it monolithically integrated within the core 104-1. The core 104-2 includes an eDTC 110 in a cavity 106. In some embodiments, the cores 104 may be provided by different manufacturers, together with the CMIL 108 and the eDTC 110 included therein. In other embodiments, one manufacturer may provide the cores 104 but without the CMIL 108 and the eDTC 110, and one or more other manufacturers may provide the CMIL 108 and the eDTC 110. In some embodiments, the cores 104 may include conductive contacts 202 on top and bottom surfaces of the cores 104 as well as on top and bottom surfaces of the CMIL 108 and the eDTC 110, as shown in FIG 2A. Conductive contacts 202 may take any embodiments of the conductive contacts discussed with reference to FIG. 1 (e.g., any embodiments of the conductive contacts 131, 138, 139, 144, and/or 145). In some embodiments, one or more gaps may be present between sidewalls of the cavity 106 and the eDTC 110. In some embodiments, the widths of such gaps may be between about 5 micron and 500 micron, e.g., between about 10 micron and 200 micron, or between about 50 micron and 100 micron. In some embodiments, such gaps may later be filled with the bonding material 114 or with the dielectric material 112A that is different from the bonding material 114.

FIG. 2B illustrates an assembly 200B in which the cores 104-1 and 104-2 of FIG. 2A are attached to one another. As shown in FIG. 2B, a bonding material 114 may be used to attach the bottom face of the core 104-1 and the top face of the core 104-2. In some embodiments, a thickness of the bonding material 114 (i.e., a dimension measured along the z-axis of the coordinate system 105) may be between about 50 micron and 5000 micron, e.g., between about 200 micron and 500 micron, e.g., about 300 micron. To bond the cores 104-1 and 104-2 together, a layer of a bonding material 114 may be placed between the cores 104-1 and 104-2. Material such as pre-preg may serve as both an adhesive and a dielectric layer providing electrical insulation between the cores 104-1 and 104-2. Then, a stack of the core 104-2, the bonding material 114, and the core 104-1 may be placed into a lamination press, where heat (e.g., temperatures 100-200°C) may be applied to soften the bonding material 114 (e.g., to soften the resin of a material such as pre-preg), and pressure (e.g., pressure ranging from 200-500 psi) can ensure uniform bonding while minimizing voids. As the resin flows, it may fill gaps between the cores 104-1 and 104-2, providing both mechanical stability and electrical insulation. In some embodiments, the resin may undergo a partial curing during lamination, followed by a full curing cycle with controlled heating, solidifying the bonding material 114 into a rigid layer that securely bonds the cores 104-1 and 104-2 together. Although FIG. 1, FIG. 2B, and other drawings illustrate the dielectric material 112A in the cavity 106, in some embodiments, some of the bonding material 114 may flow into the cavity 106 during the bonding of the cores 104. In such embodiments, the space in the cavity 106 not occupied by the eDTC 110 may either partially or fully be filled with the bonding material 114.

FIG. 2C illustrates an assembly 200C in which the remaining space of the cavity 106 in the core 104-2 of FIG. 2B is at least partially filled with a dielectric material 112A and first layers of interconnects are formed on surfaces of the cores 104-1 and 104-2 opposite the surfaces at the bonding interface. To that end, a layer of a dielectric material 112B may be provided over a surface 206-1 of the core 104-1 and over a surface 206-2 of the core 104-2, with conductive pathways 208 (e.g., conductive traces and conductive vias) provided in the dielectric material 112B. In some embodiments, the material compositions of the dielectric material 112A and dielectric material 112B may be substantially the same. In other embodiments, material compositions of the dielectric material 112A and dielectric material 112B may be different; e.g., the dielectric material 112A may include a material that can fill the narrow gaps in the cavity 106, while the dielectric material 112B does not have to be a material that can easily flow into the gaps.

Conductive pathways 208 of the assembly 200C may take any embodiments of the conductive pathways 116 discussed with reference to FIG. 1. As shown in FIG. 2C, some of the conductive pathways 208 may be connected to the conductive contacts 202 at the surface CMIL 108 and to the conductive contacts 202 at the surface of the eDTC 110. The dielectric material 112B may serve as an insulating barrier between conductive pathways 208. Any suitable techniques may be used to form the dielectric material 112B with the conductive pathways 208, e.g., any suitable combination of patterning techniques such as photolithography, to define the areas where conductive interconnects will be formed. Conductive material, such as copper, is then deposited into the patterned areas using techniques like electroplating or sputtering. After deposition, the excess conductive material is removed, leaving the desired conductive pathways 208 within the dielectric layer. The resulting structure allows for electrical connections between different parts of the assembly 200C, such as between the conductive contacts 202 at the surface CMIL 108 or the conductive contacts 202 at the surface of the eDTC 110 and a layer 210 of a conductive material (e.g., an unpatterned conductive material) at the surface of the dielectric material 112B, while maintaining insulation between the conductive pathways 208.

FIG. 2D illustrates an assembly 200D in which one or more additional layers of the dielectric material 112B with the conductive pathways 208 are formed over the first layers on the surfaces 206-1 and 206-2. Techniques such as those described with reference to FIG. 2C may be used to provide such additional layers of the dielectric material 112B with the conductive pathways 208.

FIG. 2E illustrates an assembly 200E in which conductive through-vias 130 are formed between the first side 122-1 and the second side 122-2 of the assembly. As also shown in FIG. 2E, a layer 216 of a conductive material (e.g., an unpatterned conductive material) may be provided at the sides 122-1 and 122-2 after formation of the conductive through-vias 130. In some embodiments, the conductive through-vias 130 may be lined with a conductive material 232 and the remaining space may at least partially be filled with a dielectric material 234, as shown in FIG. 2E. The conductive material 232 may, e.g., include copper or any other metals, while dielectric material 234 may include any of the dielectric materials described above. In this configuration, the conductive material 232 serves to create an electrical path between the different layers, while the dielectric material 234 may serve to enhance the mechanical strength of the via or to maintain a more uniform layer of insulation between the conductive paths. In other embodiments, the conductive through-vias 130 may be completely filled with the conductive material 232 (not shown). The conductive filling may ensure low resistance and high performance for the inter-layer connection. How the conductive through-vias 130 may be implemented may depend on the design requirements of the package and the desired electrical and mechanical properties of the through-vias 130.

FIG. 2F illustrates an assembly 200F in which the layer 216 is patterned to form the conductive contacts 131 at the first side 122-1 and the second side 122-2 of the assembly. To that end, any suitable patterning technique may be used, e.g., photolithography. The assembly 200F may be the multilayer core package 102 which may subsequently be incorporated into a microelectronic assembly such as the microelectronic assembly 100 of FIG. 1

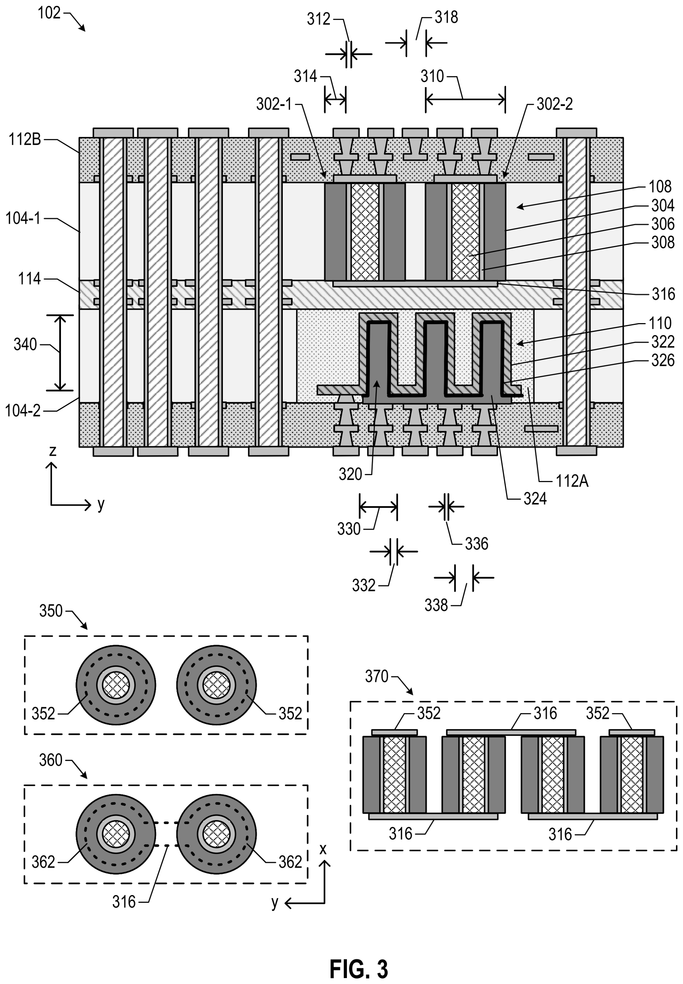

FIG. 3 is a cross-sectional side view illustrating example details of a CMIL 108 and an eDTC 110 in a multilayer core package 102, in accordance with some embodiments.

As shown in FIG. 3, in some embodiments, a CMIL 108 may include two structures 302 (individually labeled as structures 302-1 and 302-2) formed in respective openings in the core 104-1. Each structure 302 may include a magnetic material 304 on sidewalls of the respective opening in the core 104-1, a dielectric material 306 extending vertically substantially in the middle of the structure 302, and a layer of a conductive material 308 between the magnetic material 304 and the dielectric material 306. Because the dielectric material 306 is encircled by the conductive material 308 and the magnetic material 304, the dielectric material 306 may be referred to as a "dielectric plug" or simply a "plug" in the CMIL 108 or in the structures 302.

The magnetic material 304 may include any suitable high-permeability material for enhancing inductance and magnetic efficiency. In some embodiments, the magnetic material 304 may include an Ajinomoto Magnetic Paste (AMP), which is a high-permeability composite material. In some embodiments, the AMP used to implement the magnetic material 304 may include a polymeric binder and magnetic fillers, as well as, possibly, one or more solvents and additives to enhance its performance. The magnetic fillers may include ferromagnetic or ferrimagnetic particles, including iron-based alloys (Fe, Fe-Si, Fe-Ni, Fe-Co), ferrites (MnZn or NiZn ferrite powders), and amorphous or nanocrystalline soft magnetic materials, which provide high permeability and low coercivity to improve inductance and minimize core losses. These magnetic particles may be dispersed within a polymeric binder such as a thermosetting polymer matrix, e.g. epoxy or polyimide, ensuring mechanical stability and compatibility with semiconductor packaging processes. If used, one or more solvents may facilitate the paste application and evaporate during curing, while additives may help control viscosity, adhesion, and thermal stability, making AMP suitable for applying to the sidewalls of the openings for the structures 302 in the core 104-1.

The dielectric material 306 may include any suitable dielectric material, e.g., any of the materials described with reference to the dielectric material 112C. In some embodiments, the dielectric material 306 may include an epoxy-based dielectric, such as polyethyl epoxy (a blend of polyethylene and epoxy), bisphenol A epoxy (BPA), epoxy-polyimide composites, ABF, or polyepoxide (general epoxy resins). The conductive material 308 may include any suitable conductive materials, e.g., a metal such as copper. Together, the conductive material 308 and the dielectric material 306 may provide a conductive core, where the conductive material 308 can carry the main current and serve as the primary conductor of the inductor loop. As shown in FIG. 3, at the top of the core 104-1 (e.g., at the side of the core 104-1 that is opposite to the side attached to the core 104-2), each of the structures 302 is conductively coupled/connected to respective conductive pathways in the dielectric material 112B. To complete the loop, the structures 302 are conductively coupled/connected to one another by a conductive trace 316 at the bottom of the core 104-1 (e.g., at the side of the core 104-1 that is attached to the core 104-2 using the bonding material 114), as is also shown in FIG. 3.

In some embodiments, a width 310 of a structure 302 may be between about 50 and 750 micron, e.g., between about 200 and 1000 micron. In some embodiments, a thickness 314 of the magnetic material 304 on a sidewall of the structure 302 may be between about 5% and 40%, e.g., between about 10% and 20% of the width 310. In some embodiments, the thickness 314 of the magnetic material 304 on a sidewall of the structure 302 may be between about 100 and 500 micron, e.g., between about 200 micron and 400 micron, e.g., around 300 micron. In some embodiments, a thickness 312 of the dielectric material 306 on a sidewall of the structure 302 covered with the magnetic material 304 may be between about 1% and 20%, e.g., between about 1% and 10% of the width 310. In some embodiments, a diameter of the dielectric material 306 in the middle of the structures 302 may be between about 25 and 300 micron, e.g., between about 50 micron and 150 micron, e.g., around 100 micron. In some embodiments, a distance 318 between the structures 302 may be between about 10% and 200%, e.g., between about 10% and 50% of the width 310. In some embodiments, the distance 318 between the structures 302 may be between about 25 and 300 micron, e.g., between about 50 micron and 150 micron, e.g., around 100 micron.

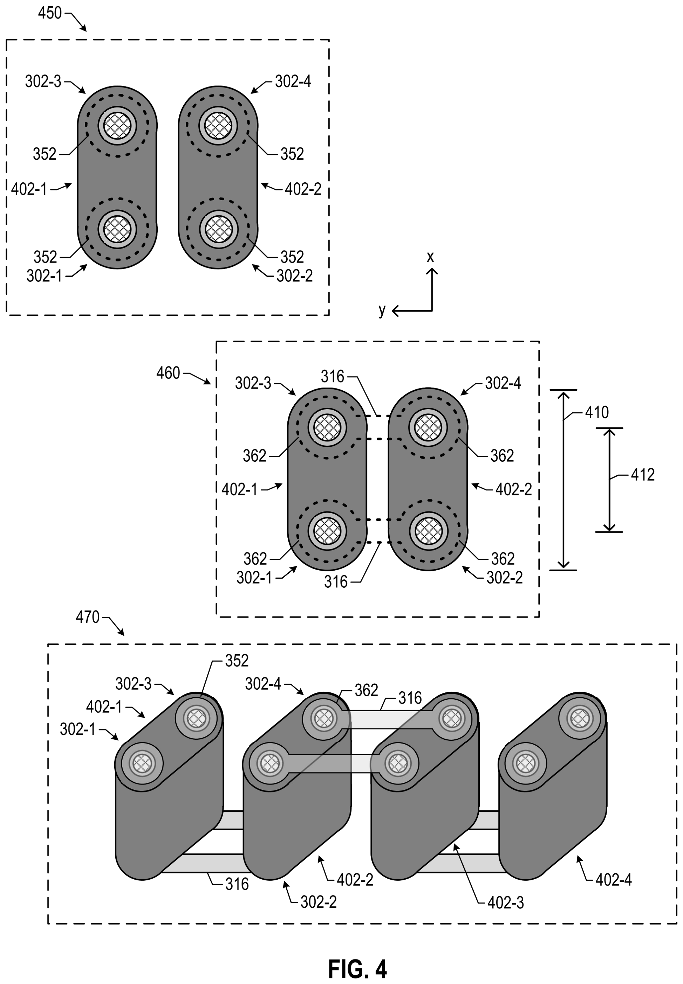

In some embodiments, the dielectric material 306 and the conductive material 308 may be coaxial. In some embodiments, the dielectric material 306, the conductive material 308, and the magnetic material 304 may be coaxial, as is shown with the top-down views of the structures 302 shown at the bottom of FIG. 3 with an inset 350 and an inset 360. In other embodiments, the dielectric material 306 and the conductive material 308 may be coaxial but the magnetic material 304 may not be coaxial, as shown in FIG. 4.

Turning to the details of the insets 350 and 360 of FIG. 3, both insets 350 and 360 illustrate top-down views of the structures 302 (e.g., views of the x-y plane of the coordinate system 105), where the inset 350 illustrates the top side of the structures 302 (i.e., the side farthest away from the bonding material 114), while the inset 360 illustrates the bottom side of the structures 302 (i.e., the side closest to the bonding material 114). Dotted contours shown in the insets 350, 360 illustrate outlines of the conductive materials forming conductive contacts as described herein. As shown in the inset 350, at the top, a respective conductive contact 352 (e.g., a conductive pad) is provided for each of the structures 302, where the individual conductive contacts 352 are then conductively coupled to the conductive pathways 116 in the dielectric materials 112B, 112C, and 112D and eventually to the FIVR 118 in the component 124. As shown in the inset 360, at the bottom, a similar respective conductive contact 362 (e.g., a conductive pad) may be provided for each of the structures 302, where the two conductive contacts 362 may be connected (conductively coupled) to one another by the conductive trace 316. The conductive contacts 352 and 362 may be substantially the same except that the reference numeral "352" is used herein to indicate a conductive contact 352 that provides an individual connection to one of the terminals of the CMIL 108, while the reference numeral "362" is used herein to indicate conductive contacts that are coupled to one another with a conductive trace 316 (thus, the reference numeral "362" is used herein to indicate conductive contacts that provide connections to multiple terminals of the CMIL 108). A "terminal" of the CMIL 108 may be considered to be the conductive materials 308 within the structures 302.

Although only a single pair of structures 302 are shown in FIG. 3, in other embodiments, the CMIL 108 may include multiple such pairs. One example of such a CMIL 108 is shown in an inset 370 of FIG. 3, illustrating a total of four structures 302. The inset 370 illustrates how, from left to right, the first two structures 302 are coupled to one another by a conductive trace 316 on one side of the structures 302 (e.g., at the bottom, as shown in the inset 370), then the second and third structures 302 are coupled to one another by another conductive trace 316 on the other side of the structures 302 (e.g., at the top, as shown in the inset 370), and then the third and fourth structures 302 are coupled to one another by a third conductive trace 316 on the same side of the structures 302 as the first and second structures 302 (e.g., at the bottom, as shown in the inset 370). Individual respective conductive contacts 352 to the remaining terminals of the structures 302 (e.g., to the top side of the first structures 302 and to the top side of the fourth structure 302) are also illustrated in the inset 370.

As shown in FIG. 3, in some embodiments, an eDTC 110 may include one or more (typically a plurality of) trenches 320. Three trenches 320 are shown as an example of FIG. 3, although any other number may be used in other embodiments. The trenches may extend along the x-axis of the coordinate system 105 used in the present drawings. Sidewalls and bottoms of the trenches 320 may be lined with a conductive material 322 forming a first capacitor electrode of the eDTC 110. The trenches 320 lined with the conductive material 322 may further include a conductive material 324 forming a second capacitor electrode of the eDTC 110 and an insulator material 326 separating the conductive material 322 and the conductive material 324 and forming a capacitor insulator of the eDTC 110. Each of the conductive materials 322 and 324 in multiple trenches 320 may be a respective materially continuous layer of a conductive material. Similarly, the insulator material 326 in multiple trenches 320 may be a materially continuous layer of an insulator material.

In some embodiments, a width 330 of a trench 320 may be between about 5 nanometers and about 250 nanometers, e.g., between about 20 and 75 nanometers. In some embodiments, a thickness 332 of the conductive material 322 lining the trench 320 may be between about 2 nanometers and about 100 nanometers, e.g., between about 5 and 75 nanometers. In some embodiments, a thickness 336 of the insulator material 326 may be between about 1 nanometers and about 10 nanometers, e.g., between about 1 and 8 nanometers, or between about 1 and 5 nanometers. As shown in FIG. 3, individual ones of the trenches 320 may be separated from one another by a distance 338, filled with an insulator material, where the distance 338 may be between about 2 nanometers and about 100 nanometers, e.g., between about 2 and 75 nanometers. In some embodiments, a depth 340 of the trenches 320 may be between about 25 nanometers and about 200 nanometers, e.g., between about 30 and 150 nanometers, or between about 30 and 100 nanometers.

The conductive materials 322 and 324 may include any suitable metal (e.g., tungsten, titanium, tantalum, copper, ruthenium, palladium, platinum, cobalt, nickel, etc.), metal alloy, or carbides or nitrides of one or more metals. The insulator material 326 may include any suitable insulator material. In some embodiments, the insulator material 326 may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include but are not limited to, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, the insulator material 326 may be a low-k dielectric such as silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

FIG. 4 is a cross-sectional side view illustrating example alternative details of a CMIL 108 that may be included in a multilayer core package 102, in accordance with some embodiments. In particular, FIG. 4 illustrates insets 450, 460, and 470, which are similar to the insets 350, 360, and 370, respectively, of FIG. 3, but illustrating an embodiment of the CMIL 108 where the dielectric material 306 and the conductive material 308 are coaxial and the magnetic material 304 may not be coaxial. Both inset 450 and inset 460 illustrate top-down views of the structures 302 of the multilayer core package 102 as described herein (e.g., views of the x-y plane of the coordinate system 105), where the inset 450 illustrates the top side of the structures 302 (i.e., the side farthest away from the bonding material 114), while the inset 460 illustrates the bottom side of the structures 302 (i.e., the side closest to the bonding material 114). Dotted contours shown in the insets 450, 460 illustrate outlines of the conductive materials forming conductive contacts 352, 362 and the conductive traces 316 as described herein. The structures 302-1 and 302-2 of the insets 450 and 460 of FIG. 4 may be the structures 302-1 and 302-2 of the CMIL 108 shown in FIG. 3. What is different in FIG. 4 is that each of the structures 302-1 and 302-2 is further connected to another set of a plug of the dielectric material 306 and a layer of the conductive material 308 coaxial with the plug of dielectric material 306, with a single materially continuous structure of the magnetic material 304 enveloping both sets of the plug of the dielectric material 306 and the conductive material 308. For the structure 302-1, the other set of the plug of the dielectric material 306 and the conductive material 308 is labeled as a structure 302-3 in FIG. 4, and, for the structure 302-2, the other set of the plug of the dielectric material 306 and the conductive material 308 is labeled as a structure 302-4 in FIG. 4. Thus, the insets 450 and 460 of FIG. 4 illustrate embodiments of multiple magnetic inductor arrangements 402 where different pairs of structures 302 may share a single materially continuous structure of the magnetic material 304 enveloping both sets of the plug of the dielectric material 306 and the conductive material 308 of these structures 302-1. In the insets 450 and 460, a magnetic inductor arrangement 402-1 includes structures 302-1 and 302-3 sharing a single materially continuous structure of the magnetic material 304 surrounding/encircling two distinct pairs of a plug of the dielectric material 306 and the conductive material 308, while a magnetic inductor arrangement 402-2 includes structures 302-2 and 302-4 sharing another single materially continuous structure of the magnetic material 304 surrounding/encircling two other distinct pairs of a plug of the dielectric material 306 and the conductive material 308.

Although only a single pair of magnetic inductor arrangements 402 are shown in the insets 450 and 460 of FIG. 4, in other embodiments, the CMIL 108 may include multiple pairs of magnetic inductor arrangements 402. One example of such a CMIL 108 is shown in an inset 470 of FIG. 4, showing two pairs of magnetic inductor arrangements 402, the first pair including magnetic inductor arrangements 402-1 and 402-2 as in the insets 450 and 460, and the second pair including magnetic inductor arrangements 402-3 and 404-4, similar to the first pair. The inset 470 is similar to the inset 370, but is for the CMIL 108 as described with reference to the insets 450 and 460 and is, therefore, shown as a perspective drawing, to better illustrate various conductive contacts 352 and conductive traces 316 connecting multiple terminals when two pairs of pairs of magnetic inductor arrangements 402 may be implemented in a CMIL 108. As shown in the inset 470, the layers of the conductive material 308 of the two structures 302 of the magnetic inductor arrangement 402-1 may be conductively coupled to the layers of the conductive material 308 of the two structures 302 of the magnetic inductor arrangement 402-1 with two traces 316 on one side of the magnetic inductor arrangements 402 (e.g., at the bottom, as shown in FIG. 4). Similarly, the layers of the conductive material 308 of the two structures 302 of the magnetic inductor arrangement 402-4 may be conductively coupled to the layers of the conductive material 308 of the two structures 302 of the magnetic inductor arrangement 402-3 with two traces 316 on the same side of the magnetic inductor arrangements 402 (e.g., at the bottom, as shown in FIG. 4). Further, the layers of the conductive material 308 of the two structures 302 of the magnetic inductor arrangement 402-2 may be conductively coupled to the layers of the conductive material 308 of the two structures 302 of the magnetic inductor arrangement 402-3 with two traces 316 on the other side of the magnetic inductor arrangements 402 (e.g., at the top, as shown in FIG. 4).

For the magnetic inductor arrangements 402 as illustrated in FIG. 4, in some embodiments, a length 410 of the magnetic material 304 surrounding/encircling two distinct pairs of a plug of the dielectric material 306 and the conductive material 308 (e.g., a dimension along the x-axis of the coordinate system 105 shown in the present drawings) may be between about 400 micron and 1100 micron, e.g., between about 600 micron and 800 micron. In some embodiments, a pitch 412 (e.g., a center-to-center distance, also a dimension along the x-axis of the coordinate system 105 shown in the present drawings) between two plugs of the dielectric material 306 of a given magnetic inductor arrangement 402 may be between about 200 micron and 500 micron, e.g., between about 250 micron and 400 micron. Other dimensions described with reference to FIG. 3 may be applicable to the magnetic inductor arrangements 402 shown in FIG. 4.

FIG. 5 is a cross-sectional side view illustrating example details of dielectric materials of a multilayer substrate 107 with the multilayer core package 102, in accordance with some embodiments. FIG. 5 illustrates that, in some embodiments, materials of the dielectric material 112C and those of the dielectric material 112B, the cores 104, and the bonding material 114 may be clearly distinguishable in a cross-sectional image. For example, the dielectric material 112C may include an epoxy film (e.g., ABF) with filler particles 502 that may be substantially spherical, as illustrated in FIG. 5. On the other hand, the dielectric material 112B, the cores 104, and the bonding material 114 may also include an epoxy-based material but with fibers or clothes 504 instead of the filler particles 502, where the fibers or clothes would be seen as elongated structures (not spherical).

The microelectronic assemblies 100 disclosed herein, in particular the multilayer core packages 102 as described herein, may be included in any suitable electronic component. FIGS. 6-9 illustrate various examples of apparatuses that may include, or be included in, any of the microelectronic assemblies 100 and/or the multilayer core packages 102 as discussed with reference to FIGS. 1-5.

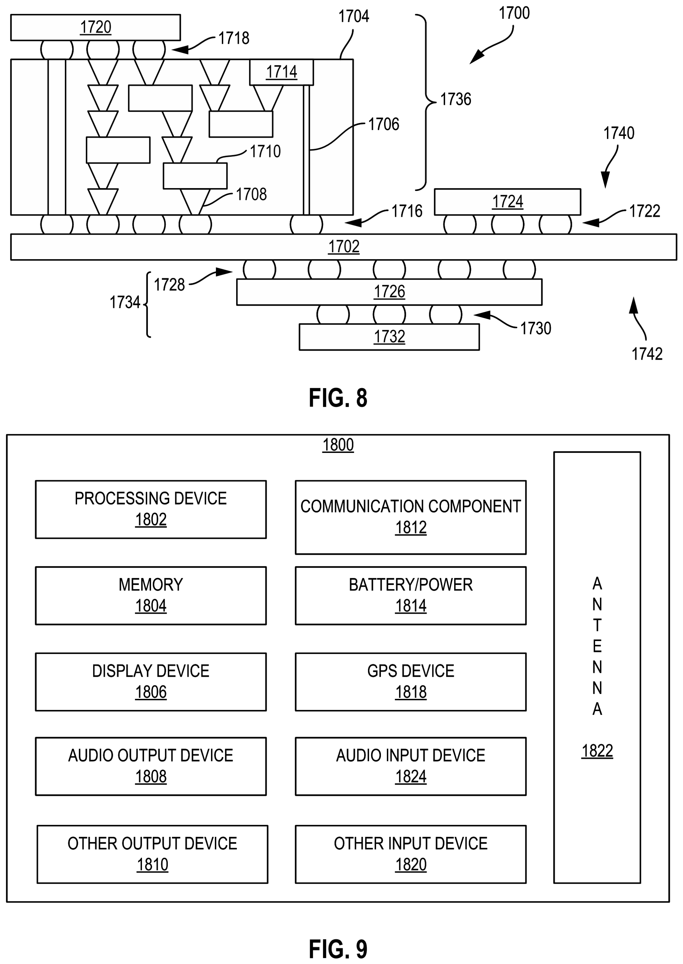

FIG. 6 is a top view of a wafer 1500 and dies 1502 that may be included in any of the microelectronic assemblies 100 as described herein. For example, a die 1502 may be any of the dies/components (e.g., the landside VR 120, the FIVR 118, the components 124, or the components 126) described herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more transistors (e.g., some of the transistors 1640 of FIG. 7, discussed below) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 9) or other logic that is configured to store information in the memory devices or execute instructions stored in the memory array.

FIG. 7 is a side, cross-sectional view of an IC device 1600 that may be included in any of the microelectronic assemblies 100 as described herein. For example, an IC device 1600 may be provided on/in any of the dies/components (e.g., the landside VR 120, the FIVR 118, the components 124, or the components 126) described herein. The IC device 1600 may be formed on a substrate 1602 (e.g., the wafer 1500 of FIG. 6) and may be included in a die (e.g., the die 1502 of FIG. 6). The substrate 1602 may be a semiconductor substrate composed of semiconductor material systems including, for example, N-type or P-type materials systems (or a combination of both). The substrate 1602 may include, for example, a crystalline substrate formed using a bulk silicon or a silicon-on-insulator (SOI) substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group III-V materials (i.e., materials from groups III and V of the periodic system of elements), group II-VI (i.e., materials from groups II and IV of the periodic system of elements), or group IV materials (i.e., materials from group IV of the periodic system of elements) may also be used to form the substrate 1602. Although a few examples of materials from which the substrate 1602 may be formed are described here, any material that may serve as a foundation for an IC device 1600 may be used. The substrate 1602 may be part of a singulated die (e.g., the dies 1502 of FIG. 6) or a wafer (e.g., the wafer 1500 of FIG. 6).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 7 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one P-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top face of the substrate. In other embodiments, at least one of the metal layers that form the gate electrode may simply be a planar layer that is substantially parallel to the top face of the substrate and does not include sidewall portions substantially perpendicular to the top face of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion-implantation process. In the latter process, the substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., the transistors 1640) of the device layer 1604 through one or more interconnect layers disposed on the device layer 1604 (illustrated in FIG. 7 as interconnect layers 1606, 1608, and 1610). For example, electrically conductive features of the device layer 1604 (e.g., the gate 1622 and the S/D contacts 1624) may be electrically coupled with the interconnect structures 1628 of the interconnect layers 1606, 1608, and 1610. The one or more interconnect layers 1606, 1608, and 1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 7). Although a particular number of interconnect layers 1606, 1608, and 1610 is depicted in FIG. 7, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in the direction of a plane that is substantially parallel with a surface of the substrate 1602 upon which the device layer 1604 is formed. For example, the lines 1628a may route electrical signals in a direction in and out of the page from the perspective of FIG. 7. The vias 1628b may be arranged to route electrical signals in a direction of a plane that is substantially perpendicular to the surface of the substrate 1602 upon which the device layer 1604 is formed. In some embodiments, the vias 1628b may electrically couple lines 1628a of different interconnect layers 1606, 1608, and 1610 together.

The interconnect layers 1606, 1608, and 1610 may include a dielectric material 1626 disposed between the interconnect structures 1628, as shown in FIG. 7. In some embodiments, the dielectric material 1626 disposed between the interconnect structures 1628 in different ones of the interconnect layers 1606, 1608, and 1610 may have different compositions; in other embodiments, the composition of the dielectric material 1626 between different interconnect layers 1606, 1608, and 1610 may be the same.

A first interconnect layer 1606 may be formed above the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606, 1608, and 1610. In FIG. 7, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606, 1608, and 1610; for example, the conductive contacts 1636 may include other analogous features (e.g., posts) that route the electrical signals to external components.

FIG. 8 is a side, cross-sectional view of an IC device assembly 1700 that may include a multilayer core package 102 or a microelectronic assembly 100 in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the microelectronic assemblies 100 discussed above, e.g., may include one or more microelectronic assemblies 100 as discussed with reference to FIGS. 1-5, and/or may include one or more multilayer core packages 102 as discussed with reference to FIGS. 1-5.

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 8 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 8), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 8, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 7), an IC device (e.g., any of the IC devices described herein, or any combination of such IC devices), or any other suitable component. Generally, the package interposer 1704 may spread a connection to a wider pitch or reroute a connection to a different connection. For example, the package interposer 1704 may couple the IC package 1720 (e.g., a die) to a set of ball grid array (BGA) conductive contacts of the coupling components 1716 for coupling to the circuit board 1702. In the embodiment illustrated in FIG. 8, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. In any of these embodiments, the package interposer 1704 may include multiple metal layers separated from one another by layers of dielectric material and interconnected by electrically conductive vias. The package interposer 1704 may include metal lines 1710 and vias 1708, including but not limited to conductive vias 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art. In some embodiments, the package interposer 1704 may be or may include a multilayer core package 102 as described herein. For example, in some embodiments, the package interposer 1704 may be or may include a multilayer substrate 107 as described herein.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 8 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 9 is a block diagram of an example communication device 1800 that may include one or more microelectronic assemblies 100 and/or one or more multilayer core packages 102 in accordance with any of the embodiments disclosed herein. A handheld communication device or a laptop communication device may be examples of the communication device 1800. Any suitable ones of the components of the communication device 1800 may include one or more of the microelectronic assemblies 100, IC packages 1720, 1724, IC device assemblies 1700, IC devices 1600, or dies 1502 disclosed herein. In particular, any suitable ones of the components of the communication device 1800 may include one or more multilayer core packages 102 as described herein, e.g., as a part of a microelectronic assembly 100 as described herein. A number of components are illustrated in FIG. 9 as included in the communication device 1800, but any one or more of these components may be omitted or duplicated, as suitable for the application. In some embodiments, some or all of the components included in the communication device 1800 may be attached to one or more motherboards. In some embodiments, some or all of these components are fabricated onto a single system-on-a-chip (SoC) die.

Additionally, in various embodiments, the communication device 1800 may not include one or more of the components illustrated in FIG. 9, but the communication device 1800 may include interface circuitry for coupling to the one or more components. For example, the communication device 1800 may not include a display device 1806, but may include display device interface circuitry (e.g., a connector and driver circuitry) to which a display device 1806 may be coupled. In another set of examples, the communication device 1800 may not include an audio input device 1824 or an audio output device 1808 but may include audio input or output device interface circuitry (e.g., connectors and supporting circuitry) to which an audio input device 1824 or audio output device 1808 may be coupled.

The communication device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The communication device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded DRAM (eDRAM) or spin transfer torque magnetic RAM (STT-MRAM). In some embodiments, the processing device 1802 may include a multilayer core package 102 as described herein. For example, in some embodiments, the processing device 1802 may be or may include a multilayer substrate 107 or a microelectronic assembly 100 as described herein.

In some embodiments, the communication device 1800 may include a communication module 1812 (e.g., one or more communication modules). For example, the communication module 1812 may be configured for managing wireless communications for the transfer of data to and from the communication device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. The communication module 1812 may be, or may include, any of the microelectronic assemblies 100 disclosed herein.

The communication module 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication module 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication module 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication module 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication module 1812 may operate in accordance with other wireless protocols in other embodiments. The communication device 1800 may include an antenna 1822 to facilitate wireless communications and/or to receive other wireless communications (such as AM or FM radio transmissions).

In some embodiments, the communication module 1812 may manage wired communications, such as electrical, optical, or any other suitable communication protocols (e.g., the Ethernet). As noted above, the communication module 1812 may include multiple communication modules. For instance, a first communication module 1812 may be dedicated to shorter-range wireless communications such as Wi-Fi or Bluetooth, and a second communication module 1812 may be dedicated to longer-range wireless communications such as global positioning system (GPS), EDGE, GPRS, CDMA, WiMAX, LTE, EV-DO, or others. In some embodiments, a first communication module 1812 may be dedicated to wireless communications, and a second communication module 1812 may be dedicated to wired communications. In some embodiments, the communication module 1812 may support millimeter wave communication.

The communication device 1800 may include battery/power circuitry 1814. The battery/power circuitry 1814 may include one or more energy storage devices (e.g., batteries or capacitors) and/or circuitry for coupling components of the communication device 1800 to an energy source separate from the communication device 1800 (e.g., AC line power). In some embodiments, the battery/power circuitry 1814 may include a multilayer core package 102 as described herein. For example, in some embodiments, the battery/power circuitry 1814 may include a multilayer substrate 107 as described herein.

The communication device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The communication device 1800 may include an audio output device 1808 (or corresponding interface circuitry, as discussed above). The audio output device 1808 may include any device that generates an audible indicator, such as speakers, headsets, or earbuds.

The communication device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The communication device 1800 may include a GPS device 1818 (or corresponding interface circuitry, as discussed above). The GPS device 1818 may be in communication with a satellite-based system and may receive a location of the communication device 1800, as known in the art.

The communication device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The communication device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The communication device 1800 may have any desired form factor, such as a handheld or mobile communication device (e.g., a cell phone, a smart phone, a mobile internet device, a music player, a tablet computer, a laptop computer, a netbook computer, an ultrabook computer, a personal digital assistant (PDA), an ultra-mobile personal computer, etc.), a desktop communication device, a server or other networked computing component, a printer, a scanner, a monitor, a set-top box, an entertainment control unit, a vehicle control unit, a digital camera, a digital video recorder, or a wearable communication device. In some embodiments, the communication device 1800 may be any other electronic device that processes data.

The following paragraphs provide examples of various ones of the embodiments disclosed herein.

Example 1 provides a microelectronic assembly that includes a first core; a magnetic inductor (e.g., a part of a CMIL) at least partially embedded in the first core; a second core attached to the first core; and a trench capacitor (e.g., a part of an eDTC) at least partially embedded in the second core, in which a footprint of the magnetic inductor at least partially overlaps with a footprint of the trench capacitor.

Example 2 provides the microelectronic assembly according to example 1, in which the magnetic inductor and the trench capacitor are vertically stacked with respect to one another.

Example 3 provides the microelectronic assembly according to examples 1 or 2, in which the trench capacitor is an embedded deep trench capacitor including a plurality of trenches.

Example 4 provides the microelectronic assembly according to any one of the preceding examples, further including a die; and a stack of dielectric layers including conductive vias and conductive traces, in which the die is conductively coupled to the stack of dielectric layers, and at least one of the conductive vias has a tapered shape that narrows in a direction away from the die, in which the stack of dielectric layers is between the first core and the die.

Example 5 provides the microelectronic assembly according to example 4, in which the stack is a first stack and the microelectronic assembly further includes a second stack of dielectric layers including conductive vias and conductive traces, in which at least one of the conductive vias of the second stack of dielectric layers has a tapered shape that narrows in a direction towards the die, in which the second core is between the second stack of dielectric layers and the first core.

Example 6 provides the microelectronic assembly according to example 5, in which the first core is between the second core and the first stack of dielectric layers.

Example 7 provides the microelectronic assembly according to examples 5 or 6, further including a conductive through-via extending through the first core, the second core, and a bonding interface between the first core and the second core.

Example 8 provides the microelectronic assembly according to example 7, in which the conductive through-via is conductively coupled to: one or more of the conductive vias or one or more of the conductive traces of the first stack of dielectric layers, and one or more of the conductive vias or one or more of the conductive traces of the second stack of dielectric layers.

Example 9 provides the microelectronic assembly according to examples 7 or 8, in which the conductive through-via does not have a tapered shape.

Example 10 provides the microelectronic assembly according to any one of examples 5-9, in which: the die includes a first voltage regulator, the magnetic inductor is conductively coupled to the first voltage regulator, the microelectronic assembly further includes a second voltage regulator, the second stack of dielectric layers is between the second voltage regulator and the second core, and the trench capacitor is conductively coupled to the second voltage regulator.

Example 11 provides the microelectronic assembly according to example 10, in which the second voltage regulator is a surface-mounted component.

Example 12 provides the microelectronic assembly according to example 10, in which the die is a first die, the microelectronic assembly further includes a second die, and the second voltage regulator is in the second die.

Example 13 provides the microelectronic assembly according to any one of examples 10-12, in which: the first voltage regulator is a fully integrated voltage regulator, and the second voltage regulator is a landside voltage regulator.

Example 14 provides the microelectronic assembly according to any one of examples 4-13, in which: the die is a first die, the microelectronic assembly further includes a second die at least partially coplanar with the first die, and the microelectronic assembly further includes a bridge, in which the bridge is conductively coupled with the first die and the second die.

Example 15 provides the microelectronic assembly according to example 14, in which the bridge is at least partially in a recess in the stack of dielectric layers.

Example 16 provides the microelectronic assembly according to any one of examples 4-9, in which: the die includes a voltage regulator, and the magnetic inductor is conductively coupled to the voltage regulator.

Example 17 provides a microelectronic assembly that includes a first dielectric layer; a magnetic inductor integrated in the first dielectric layer; a second dielectric layer; a bonding interface between the first dielectric layer and the second dielectric layer; and a capacitor in a cavity in the second dielectric layer, in which the magnetic inductor includes a first dielectric core extending from a first face to an opposite second face of the first dielectric layer, a layer of a first conductive material coaxial with the first dielectric core, a second dielectric core extending from the first face to the second face of the first dielectric layer, a layer of a second conductive material coaxial with the second dielectric core, and a magnetic material laterally surrounding the layer of the first conductive material and the layer of the second conductive material, and wherein a footprint of the magnetic inductor at least partially overlaps with a footprint of the cavity in the second dielectric layer.

Example 18 provides the microelectronic assembly according to example 17, further including a first voltage regulator conductively coupled to the magnetic inductor; and a second voltage regulator conductively coupled to the capacitor.

Example 19 provides a multilayer substrate that includes a first stack of dielectric layers including conductive vias and conductive traces; a first additional dielectric layer; a second additional dielectric layer, in which the first additional dielectric layer is between the first stack of dielectric layers and the second additional dielectric layer; a bonding interface between the first additional dielectric layer and the second additional dielectric layer; and a second stack of dielectric layers including conductive vias and conductive traces, in which the second additional dielectric layer is between the first additional dielectric layer and the second stack of dielectric layers, in which: the first additional dielectric layer includes a magnetic inductor, the second additional dielectric layer includes a capacitor, and the magnetic inductor and the capacitor are vertically stacked with respect to one another.

Example 20 provides a multilayer substrate according to example 19, in which: at least one of the conductive vias of the first stack of dielectric layers has a tapered shape that narrows in a direction towards the bonding interface, and at least one of the conductive vias of the second stack of dielectric layers has a tapered shape that narrows in a direction towards the bonding interface.

Example 21 provides a semiconductor device assembly that includes a multilayer core package; and a circuit board conductively coupled to the multilayer core package, in which the multilayer core package includes a first core, a CMIL at least partially embedded in the first core, a second core attached to the first core, and an eDTC at least partially embedded in the second core, in which a footprint of the CMIL at least partially overlaps with a footprint of the eDTC.

Example 22 provides the semiconductor device assembly according to example 21, in which the CMIL and the eDTC are vertically stacked with respect to one another.

Example 23 provides the semiconductor device assembly according to examples 21 or 22, in which the eDTC includes a plurality of trenches.

Example 24 provides the semiconductor device assembly according to any one of examples 21-23, further including a die; and a stack of dielectric layers including conductive vias and conductive traces, in which the die is conductively coupled to the stack of dielectric layers, and at least one of the conductive vias has a tapered shape that narrows in a direction away from the die, in which the stack of dielectric layers is between the first core and the die.

Example 25 provides the semiconductor device assembly according to example 24, in which the stack is a first stack and the semiconductor device assembly further includes a second stack of dielectric layers including conductive vias and conductive traces, in which at least one of the conductive vias of the second stack of dielectric layers has a tapered shape that narrows in a direction towards the die, in which the second core is between the second stack of dielectric layers and the first core.

Example 26 provides the semiconductor device assembly according to example 25, in which the first core is between the second core and the first stack of dielectric layers.

Example 27 provides the semiconductor device assembly according to examples 25 or 26, further including a conductive through-via extending through the first core, the second core, and a bonding interface between the first core and the second core.

Example 28 provides the semiconductor device assembly according to example 27, in which the conductive through-via is conductively coupled to: one or more of the conductive vias or one or more of the conductive traces of the first stack of dielectric layers, and one or more of the conductive vias or one or more of the conductive traces of the second stack of dielectric layers.

Example 29 provides the semiconductor device assembly according to examples 27 or 28, in which the conductive through-via does not have a tapered shape.

Example 30 provides the semiconductor device assembly according to any one of examples 25-29, in which: the die includes a first voltage regulator, the CMIL is conductively coupled to the first voltage regulator, the semiconductor device assembly further includes a second voltage regulator, the second stack of dielectric layers is between the second voltage regulator and the second core, and the eDTC is conductively coupled to the second voltage regulator.

Example 31 provides the semiconductor device assembly according to example 30, in which the second voltage regulator is a surface-mounted component.

Example 32 provides the semiconductor device assembly according to example 30, in which the die is a first die, the semiconductor device assembly further includes a second die, and the second voltage regulator is in the second die.

Example 33 provides the semiconductor device assembly according to any one of examples 30-32, in which: the first voltage regulator is a fully integrated voltage regulator, and the second voltage regulator is a landside voltage regulator.

Example 34 provides the semiconductor device assembly according to any one of examples 24-33, in which: the die is a first die, the semiconductor device assembly further includes a second die at least partially coplanar with the first die, and the semiconductor device assembly further includes a bridge, in which the bridge is conductively coupled with the first die and the second die.

Example 35 provides the semiconductor device assembly according to example 34, in which the bridge is at least partially in a recess in the stack of dielectric layers.

Example 36 provides the semiconductor device assembly according to any one of examples 24-29, in which: the die includes a voltage regulator, and the CMIL is conductively coupled to the voltage regulator.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A microelectronic assembly, comprising:
a first core;
a magnetic inductor at least partially embedded in the first core;
a second core attached to the first core; and
a trench capacitor at least partially embedded in the second core,
wherein a footprint of the magnetic inductor at least partially overlaps with a footprint of the trench capacitor.

2. The microelectronic assembly according to claim 1, wherein the magnetic inductor and the trench capacitor are vertically stacked with respect to one another.

3. The microelectronic assembly according to claims 1 or 2, wherein the trench capacitor is an embedded deep trench capacitor comprising a plurality of trenches.

4. The microelectronic assembly according to any one of the preceding claims, further comprising:
a die; and
a stack of dielectric layers comprising conductive vias and conductive traces, wherein the die is conductively coupled to the stack of dielectric layers, and at least one of the conductive vias has a tapered shape that narrows in a direction away from the die,
wherein the stack of dielectric layers is between the first core and the die.

5. The microelectronic assembly according to claim 4, wherein the stack is a first stack, and the microelectronic assembly further includes:
a second stack of dielectric layers comprising conductive vias and conductive traces, wherein at least one of the conductive vias of the second stack of dielectric layers has a tapered shape that narrows in a direction towards the die,
wherein the second core is between the second stack of dielectric layers and the first core.

6. The microelectronic assembly according to claim 5, further comprising:
a conductive through-via extending through the first core, the second core, and a bonding interface between the first core and the second core.

7. The microelectronic assembly according to any one of claims 5-6, wherein:
the die includes a first voltage regulator,
the magnetic inductor is conductively coupled to the first voltage regulator,
the microelectronic assembly further includes a second voltage regulator,
the second stack of dielectric layers is between the second voltage regulator and the second core, and
the trench capacitor is conductively coupled to the second voltage regulator.

8. The microelectronic assembly according to claim 7, wherein the second voltage regulator is a surface-mounted component.

9. The microelectronic assembly according to claim 7, wherein the die is a first die, the microelectronic assembly further includes a second die, and the second voltage regulator is in the second die.

10. The microelectronic assembly according to any one of claims 7-9, wherein:
the first voltage regulator is a fully integrated voltage regulator, and
the second voltage regulator is a landside voltage regulator.

11. The microelectronic assembly according to any one of claims 4-10, wherein:
the die is a first die,
the microelectronic assembly further includes a second die at least partially coplanar with the first die, and
the microelectronic assembly further includes a bridge, wherein the bridge is conductively coupled with the first die and the second die.

12. The microelectronic assembly according to claim 14, wherein the bridge is at least partially in a recess in the stack of dielectric layers.

13. The microelectronic assembly according to any one of claims 4-12, wherein:
the die includes a voltage regulator, and
the magnetic inductor is conductively coupled to the voltage regulator.

14. A microelectronic assembly, comprising:
a first dielectric layer;
a magnetic inductor integrated in the first dielectric layer;
a second dielectric layer;
a bonding interface between the first dielectric layer and the second dielectric layer; and
a capacitor in a cavity in the second dielectric layer,
wherein the magnetic inductor includes a first dielectric core extending from a first face to an opposite second face of the first dielectric layer, a layer of a first conductive material coaxial with the first dielectric core, a second dielectric core extending from the first face to the second face of the first dielectric layer, a layer of a second conductive material coaxial with the second dielectric core, and a magnetic material laterally surrounding the layer of the first conductive material and the layer of the second conductive material.

15. A multilayer substrate, comprising:
a first stack of dielectric layers comprising conductive vias and conductive traces;
a first additional dielectric layer;
a second additional dielectric layer, wherein the first additional dielectric layer is between the first stack of dielectric layers and the second additional dielectric layer;
a bonding interface between the first additional dielectric layer and the second additional dielectric layer; and
a second stack of dielectric layers comprising conductive vias and conductive traces, wherein the second additional dielectric layer is between the first additional dielectric layer and the second stack of dielectric layers,
wherein:
the first additional dielectric layer includes a magnetic inductor,
the second additional dielectric layer includes a capacitor, and
the magnetic inductor and the capacitor are vertically stacked with respect to one another.
